# EUROPÄISCHE PATENTSCHRIFT

(11) **EP 0 920 676 B1**
(45) Veröffentlichungstag und Bekanntmachung des Hinweises auf die Patenterteilung: **21.11.2001**
(21) Anmeldenummer: 97941936.3
(22) Anmeldetag: 13.08.1997
(51) Int. Cl.: G06K 19/077

(54) **VERFAHREN ZUR HERSTELLUNG EINER ELEKTRISCHEN UND MECHANISCHEN VERBINDUNG EINES MODULS IN EINER AUSNEHMUNG EINES KARTENKÖRPERS**
METHOD FOR MANUFACTURING AN ELECTRIC AND MECHANICAL CONNEXION OF A CHIP CARD MODULE PLACED IN A RECESS OF A CARD BODY
PROCEDE DE FABRICATION D'UNE CONNEXION ELECTRIQUE ET MECANIQUE D'UN MODULE DE CARTE A PUCE PLACE DANS UNE CAVITE D'UN CORPS DE CARTE

(30) Priorität: 22.08.1996 DE 19633939; 22.08.1996 DE 19633938; 22.08.1996 DE 19633936; 12.09.1996 DE 19637214; 12.09.1996 DE 19637213
(43) Veröffentlichungstag der Anmeldung: 09.06.1999
(73) Patentinhaber: PAV Card GmbH, 22952 Lütjensee (DE)
(72) Erfinder: WILM, Robert, D-22929 Kasseburg (DE)
(74) Vertreter: Kruspig, Volkmar, Dipl.-Ing.
(86) Internationale Anmeldenummer: EP9704427
(87) Internationale Veröffentlichungsnummer: WO9808191

(56) Entgegenhaltungen:
- EP-A- 0 671 705
- EP-A- 0 689 165
- EP-A- 0 694 871
- WO-A-96/07985
- DE-A- 4 224 994
- DE-A- 19 500 925
- US-A- 5 057 679

## Beschreibung

Die Erfindung betrifft ein Verfahren zur Herstellung einer elektrischen und mechanischen Verbindung eines in einer Ausnehmung eines Kartenkörpers einer Chipkarte eingesetzten Moduls unter Verwendung eines Heiß- oder Schmelzklebers gemäß Oberbegriff des Patentanspruchs 1, ein Verfahren zur Herstellung einer Chipkarte gemäß Oberbegriff des Patentanspruchs 4 sowie ein Fügewerkzeug zur Durchführung dieses Verfahrens.

Chipkarten für die kontaktbehaftete aber auch kontaktlose d. h. induktive Datenübertragung weisen einen mit dem Kartenkörper verbundenen Chipkarten-Modul auf, der einen auf einem Kunststoffträger befindlichen Halbleiterchip umfaßt, welcher bei kontaktbehafteten Karten mit einem galvanischen Kontaktfeld verbunden ist. In einem Kartenlesegerät werden diese Kontaktflächen elektrisch abgetastet, so daß die erforderliche Kommunikation möglich wird.

Bei kontaktlos, induktiv arbeitenden Systemen erfolgt die Datenübermittlung durch elektromagnetische Wechselfelder mittels wenigstens einer in der Chipkarte bzw. im Kartenträger angeordneten Induktionsspule.

Bei sogenannten Kombikarten sind beide oben erwähnten Systeme in einer Karte vereint. Die Kombikarte verfügt demnach sowohl über ein Kontaktfeld für die kontaktbehaftete Übertragung als auch über einen induktiv koppelbaren Kontakt. Hierfür ist es erforderlich, neben den elektrisch leitenden Verbindungen vom Halbleiterchip zum System für die kontaktbehaftete Datenübertragung auch Verbindungen zum System für die induktive Datenübermittlung herzustellen.

Zur Lösung dieses Problems wurde bereits vorgeschlagen, die elektrisch leitenden Verbindungen zwischen den Anschlußstellen und dem Mittel für die kontaktlose Datenübertragung mittels eines anisotrop leitenden Klebstoffes herzustellen. Dieser anisotrop leitende Klebstoff weist elektrisch leitende Partikel auf, welche dem Klebstoff bei der Herstellung gleichmäßig verteilt zugesetzt werden. Die Menge der leitenden Partikel im Klebstoff soll dabei so gewählt werden, daß zwischen den Anschlußstellen und dem Mittel zur kontaktlosen Datenübertragung z. B. einem entsprechenden Kontaktfeld einer Antenne genügend Partikel vorhanden sind, um eine ausreichende elektrische Verbindung entsprechender Kontaktgüte aufzubauen.

Bei dem vorstehend beschriebenen Verfahren kommt die elektrisch leitende Verbindung dadurch zustande, daß der anisotrop leitende Klebstoff zumindest im Bereich der Anschlußstellen und unter den Verbindungsstellen des Mittels für die kontaktlose Datenübertragung aufgetragen und der Klebstoff zumindest im Bereich der Anschlußstellen so weit unter Druck komprimiert wird, daß eine elektrisch leitende Brücke d. h. ein Strompfad zwischen den Anschlußstellen und dem Mittel zur kontaktlosen Datenübertragung gebildet wird. Im Falle des oben erwähnten Klebstoffes mit elektrisch leitenden Partikeln führt dies dazu, daß die Partikel im Bereich zwischen Anschlußstellen und dem Mittel für die kontaktlose Datenübertragung quasi verdichtet werden, so daß sich die einzelnen Partikel untereinander sowie die Anschluß- und Verbindungsstellen berühren, so daß die leitende Verbindung resultiert.

Üblicherweise wird der mit einem Halbleiterchip versehene Modul in eine in den Kartenkörper eingebrachte Ausnehmung implantiert, wobei hierfür auf ein Klebeverfahren unter Verwendung eines Heiß- oder Schmelzklebers (Hotmelt-Verfahren) zurückgegriffen wird.

Für die Herstellung von Kombikarten wird der erwähnte Modul mit einer weiteren Kontaktebene versehen, die mit den Anschlußstellen für das Mittel zur kontaktlosen Datenübertragung, z. B. einer Spule elektrisch zu verbinden sind. Diese elektrische Verbindung soll möglichst in einem Arbeitsgang mit der mechanischen Verbindung des Moduls bezogen auf die Ausnehmung im Kartenträger realisiert werden. Die im Kartenträger vorhandene z. B. Kupferdraht-Spule führt zu Verbindungsstellen, die beim Herstellen der Ausnehmung für den Modul z. B. durch Fräsen teilweise freigelegt werden. Bei einer derartigen Anordnung kann die Montage und das Verkleben des Moduls mit dem Kartenträger gleichzeitig mit der Herstellung der elektrisch leitenden Verbindung zwischen dem Mittel für die kontaktlose Datenübertragung und den Anschlußstellen des Moduls durchgeführt werden, wenn der anisotrop leitende Klebstoff im wesentlichen über die gesamte Oberfläche der Kartenträgerausnehmung aufgetragen wird und für eine entsprechende Temperatur und Druckeinwirkung Sorge getragen wird.

Es ist jedoch nachteilig, den anisotrop leitenden Klebstoff über die gesamte Berührungsfläche aufzutragen, da der Klebstoff zum einen teuer ist, wodurch Kostenerhöhungen resultieren, zum anderen optimale elektrische Verbindungen oft mit nicht ausreichender Klebeverbindung oder Haftung zwischen Modul und Kartenträger einhergehen. Darüber hinaus werden für das Komprimieren der leitenden Bestandteile des anisotropen Klebers höhere Druckkräfte benötigt, die an sich zur Ausführung einer sicheren Heißklebeverbindung im gleichen Maße nicht notwendig sind.

Ein bezüglich des Patentanspruchs 1 gattungsgemäßes Verfahren ist aus der DE 195 00 925 A1 bekannt.

Dort weist eine Chipkarte zur kontaktlosen Datenübertragung ein separat in den Kartenkörper eingebautes Übertragungsmodul auf. Dieses wiederum besitzt eine Antenne in Form mindestens einer Spule zur induktiven Daten- und Energieübertragung und/oder in Form elektrisch leitender Schichten zur kapazitiven Kopplung. Zur elektrischen Verbindung weist das Übertragungsmodul Anschlußflächen auf. Getrennt vom Übertragungsmodul wird in den Kartenkörper ein Chipmodul mit mindestens einem IC-Baustein und Anschlußflächen zur elektrischen Ankopplung an das Übertragungsmodul eingebaut. Hinsichtlich der Kontaktierung wird auf leitfähigen Kleber, Ultraschallverschweißen oder Kontaktierung mittels eines elastisch deformierbaren Körpers, dessen Oberfläche eine leitende Beschichtung aufweist, verwiesen.

Bei der Lehre nach EP 0 671 705 A2 wird auf ein Herstellungsverfahren zur Herstellung von kontaktbehafteten oder kontaktlosen Karten eingegangen, wobei dort ebenfalls ein Modul mit einem Halbleiterchip vorkonfektioniert und in eine Ausnehmung eines Kartenkörpers eingesetzt wird. Beim Einsetzen des Moduls in die Ausnehmung des Kartenkörpers werden gegenüberliegende Kontaktflächen in üblicher Weise elektrisch verbunden.

Ein weiteres Beispiel der elektrischen Kontaktierung für Chipkarten zur kontaktlosen Datenübertragung zeigt die EP 0 689 165 A1, wobei dort gegenüberliegende Kontaktflächen eines Moduls mit Halbleiterchip und eines Kartenkörpers über ein leitfähiges Mittel verbunden werden und wobei eine Isolierschicht dafür Sorge trägt, daß nur in den Bereichen der gegenüberliegenden Kontakte das leitfähige Mittel zur Verfügung steht.

Bei der Vorrichtung zum flächenbündigen Eindrücken eines Moduls nach DE 42 24 994 A1 wird ein Stempel verwendet, mit dessen Hilfe der Modul in eine Ausnehmung einer auf einer Platte flach aufliegenden Karte eingebracht wird. Der Stempel weist einen inneren Druckstempel und einen diesen umgebenden äußeren Referenzstempel auf. Der Druckstempel ist an seiner Unterseite im Querschnitt so bemessen, daß er ausschließlich auf dem Modul aufsitzt, während der Referenzstempel dabei die Karte rund um den Modul herum niederhält oder niederdrückt. Innerhalb des Druckstempels kann eine Heizpatrone vorgesehen sein, wobei zwischen Druckstempel und Referenzstempel eine Isolierhülse angeordnet ist, so daß die Wärmeenergie sich nur oder im wesentlichen auf den Druckstempel begrenzt und hierdurch auf das Modul übertragen werden kann. Die Erwärmung des Druckstempels erfolgt mit dem Zweck, einen Heißkleber zu einer entsprechenden Viskosität zu führen, daß der Modul entsprechend flächenbündig in die Karte eingesetzt und dort befestigt werden kann. Siehe auch Präambeln der unabhangigen Ansprüche.

Es ist daher Aufgabe der Erfindung, ein weiterentwickeltes Verfahren zur Herstellung einer elektrischen und mechanischen Verbindung eines in einer Ausnehmung eines Kartenträgers einer Chipkarte eingesetzten Moduls anzugeben, das es gestattet, unter Verwendung eines Heiß- oder Schmelzklebers in einem einzigen Arbeitsgang mit hinsichtlich der Langzeitstabilität und der Kontaktqualität optimierten Verfahrensparametern sowohl eine ausgezeichnete elektrische Kontaktierungsqualität als auch eine sichere mechanische Verbindung des Moduls im Kartenträger zu gewährleisten. Weiterhin soll ein weiterentwickeltes Verfahren zur Herstellung einer Chipkarte sowie ein Fügewerkzeug hierfür angegeben werden.

Die Lösung der Aufgabe der Erfindung erfolgt mit einem Verfahren gemäß den Merkmalen der Patentansprüche 1 oder 4 und mit einem Fügewerkzeug gemäß Anspruch 5 zur Durchführung des Verfahrens nach Anspruch 4.

Die Unteransprüche umfassen mindestens zweckmäßige Ausgestaltungen und Weiterbildungen der Erfindung.

Ein Grundgedanke der Erfindung liegt darin, zur Herstellung einer elektrischen und mechanischen Verbindung eines in einer Ausnehmung eines Kartenkörpers einer Chipkarte eingesetzten Moduls auf eine auf einem folienartigen Träger befindliche, nicht leitende Heiß- oder Schmelzkleberschicht zurückzugreifen, wobei diese Heiß- oder Schmelzkleberschicht im Bereich auszubildender elektrischer Kontakte zwischen Modul und Kartenkörper mit einer zusätzlichen leitfähigen Schicht oder mit leitfähigen Partikeln zu versehen ist. Diese zusätzliche leitfähige Schicht oder die leitfähigen Partikel können durch Lochung der Heiß- oder Schmelzkleberschicht mit anschließendem Verfüllen unter Rückgriff auf leitfähiges Material ausgebildet werden.

Die so vorbereitete Heiß- oder Schmelzkleberschicht mit leitfähigen Abschnitten wird dann am Modul oder in der Ausnehmung des Kartenträgers vorfixiert. Dieses Fixieren erfolgt so, daß die mit der zusätzlichen leitfähigen Schicht oder den leitfähigen Partikeln versehenen Abschnitte sich zwischen den Kontaktflächen des Moduls und der Ausnehmung des Kartenträgers befinden. Im Anschluß an dieses Fixieren wird in einem einzigen Druck-Temperatur-Einwirkungsschritt sowohl die mechanische Verbindung zwischen Modul und Kartenkörper als auch die elektrische Kontaktierung zwischen den sich gegenüberstehenden Kontaktflächen realisiert.

Es ist erfindungsgemäß nicht notwendig, daß die in der Regel bezogen auf die genannte Verbindungsfläche nur kleinen Kontaktflächenabschnitte wesentlich zur Klebeverbindung beitragen, vielmehr sollen hier optimierte elektrische Eigenschaften wie geringe Leitungsinduktivitäten oder ein geringer Übergangswiderstand erzielt werden. Durch die an sich übliche Heiß- oder Schmelzklebeverbindung wird für eine ausreichende Pressung und Verdichtung der leitfähigen Partikel Sorge getragen, so daß sich die gewünschte Kontakt-Langzeitstabilität ergibt.

In dem Falle, wenn erfindungsgemäß für die leitfähigen Partikel auf eine Lötpaste oder eine Lötkugel zurückgegriffen wird, kann durch definiertes Zuführen von Wärmeengergie im Kontaktbereich nach oder während des Verklebens des Moduls im Kartenkörper ein Löten erfolgen, wodurch eine weitere Erhöhung der Kontaktsicherheit gegeben ist. Die Lötstelle wird in diesem Fall von mechanischen Spannungen, Scher- oder sonstigen Kräften freigehalten, da diese auch im laufenden Einsatz der Karte von der Klebeverbindung großflächig aufgenommen werden.

Gemäß einem weiteren Grundgedanken der Erfindung kann je nach Material des Kartenträgers oder des Moduls ein geeigneter vorkonfektionierter Heiß- oder Schmelzkleber ausgewählt und hinsichtlich Schichtdicke und Auswahl der leitfähigen Partikel für den jeweiligen Einsatzfall individuell präpariert und damit optimiert werden.

Die leitfähigen Partikel oder die leitfähige Schicht sind auf die Heiß- oder Schmelzkleberfolie beispielsweise mittels eines Dispensers, einer Walze oder einem Stempel lokal aufbringbar, wobei wenn erforderlich auf eine Maske zurückgegriffen werden kann, so daß sich die Reproduzierbarkeit beim Aufbringen leitfähiger Beschichtungen erhöht. Im Falle des oberflächenseitigen Aufbringens einer leitfähigen Schicht oder von leitfähigen Partikeln wird in einer Ausführungsform der Erfindung die so aufgebrachte Schicht kurzzeitig einer thermischen Behandlung ausgesetzt, so daß ein gewisses Anschmelzen der jeweiligen Partikel und damit Haften und Verbinden mit dem Heißkleber bzw. dem Schmelzkleber die Folge ist. Durch diese Maßnahme wird sichergestellt, daß beim nachfolgenden Handling die leitfähige Schicht bzw. das leitfähige Material vor unerwünschtem Abtrag geschützt ist.

In dem Falle, wenn die Heiß- oder Schmelzkleberschicht Ausnehmungen oder Lochungen aufweist, die mit leitfähigen Partikeln wie Lötkugeln oder Lötpaste verfüllt werden, kann auf übliche und bewährte Lötmittel zurückgegriffen werden. Die Dosierung der Menge einzubringender Partikel in die Ausnehmungen oder Lochungen ist unkritisch, da Materialüberschuß bei Löten und/oder Anpressen und gleichzeitigem Verkleben in die Kleberschicht hinein verdrängt werden kann, ohne daß die Kontaktsicherheit insgesamt beeinträchtigt wird.

Ein Verbindungsmittel zur Durchführung des geschilderten Verfahrens besteht aus einer auf einer Trägerfolie befindlichen, nicht leitenden Heiß- oder Schmelzkleberschicht, welche im Bereich herzustellender elektrischer Kontakte Abschnitte mit leitfähigen Partikeln oder einer leitfähigen Schicht aufweist.

Diese Abschnitte können aus mit Lötpaste oder Leitkleber verfüllten Ausnehmungen oder Lochungen bestehen.

In einer Ausgestaltung des Verbindungsmittels befinden sich die leitfähigen Abschnitte im Inneren einer Heiß- oder Schmelzkleberschicht, wobei diese bei der Montage mittels Druck-Temperatur-Einwirkung verdrängt wird und erhabene Kontaktflächen in Wirkverbindung mit der inneren leitfähigen Schicht bzw. den inneren leitfähigen Abschnitten treten.

Zweckmäßig weist der Heiß- oder Schmelzkleber partiell elektrisch leitende, lötfähige Partikel auf. Besonders bevorzugt werden diese elektrisch leitenden, lötfähigen Partikel bereits bei der Präparation des Klebers auf einer Trägerfolie zugesetzt bzw. aufgebracht.

Größe und Menge der abschnittsweise dem Klebstoff zugesetzten Lötpartikel richtet sich nach der Art der Kontaktausbildung bzw. der Kontaktflächen der Chipkarte. Der Durchmesser einer zwischen vorgesehenen Kontaktflächen und auf einem Heiß- oder Schmelzkleberfilm befindlichen Lötkugel liegt beispielsweise im Bereich zwischen 15 und 25 *µ*m.

Die Menge der leitenden Partikel wird zweckmäßig so gewählt, daß zwischen den Anschlußstellen und dem Mittel zur kontaktlosen Datenübertragung genügend Partikeln zu liegen kommen, um eine ausreichende elektrische Verbindung durch Löten aufzubauen.

Gemäß dem auf den oben genannten Sachverhalt abgestellten Verfahren kommt die elektrisch leitende Verbindung dadurch zustande, daß der auf der Trägerfolie befindliche Klebstoff zumindest im Bereich der Anschlußstellen und/oder der Verbindungsstellen des Mittels für die kontaktlose Datenübertragung leitfähige Partikel oder Schichten aufweist, die eine elektrisch leitende Brücke zwischen Anschlußstellen und dem Mittel zur kontaktlosen Datenübertragung durch Löten bilden können.

Bei der Herstellung von Chipkarten wird überwiegend so vorgegangen, daß zunächst ein Modul hergestellt wird, der einen Kunststoffträger umfaßt, auf dem ein Halbleiterchip angeordnet ist. Der Modul wird dann mit dem Kartenkörper aus Kunststoff, z.B. Polycarbonat, verbunden. Üblicherweise wird der Modul in eine in den Kartenkörper gefräste Kavität implantiert.

Besonders bevorzugt erfolgt die Herstellung der Chipkarten unter Verwendung der oben beschriebenen, bereits bekannten Komponenten und Verfahrensschritte. Zweckmäßig verwendet die Erfindung also einen üblichen Modul, dem jedoch eine Kontaktebene mit den Anschlußstellen für das Mittel zur kontaktlosen Datenübertragung hinzugefügt wird. In der Regel wird der Modul mit zwei weiteren Anschlußstellen ergänzt, die auf übliche Weise mit dem Halbleiterchip verbunden werden.

Besonders bevorzugt sind die Anschlußstellen erhaben auf einer Oberfläche des Modulträgers, vorzugsweise der Seite, die den Halbleiterchip trägt, ausgebildet. Die Höhe der Anschlußstellen richtet sich nach Art und Abmessungen der Karte und kann beispielsweise zwischen 1 und 20 *µ*m betragen. Bevorzugt bestehen die Anschlußstellen aus Metall und werden auf an sich bekannte Weise, z.B. durch Aufkleben, Aufdrucken, Aufdampfen, Galvanisieren oder ähnliches, hergestellt. Besonders bevorzugt wird die zusätzliche Anschlußebene hergestellt, indem ein Streifen aus Metall auf den Modulträger laminiert und anschließend strukturiert wird. Lage und Größe richten sich nach Größe und Lage des Mittels für die kontaktlose Datenübermittlung und speziell dessen Verbindungsstellen.

Das Mittel für die kontaktlose Datenübermittlung, vorzugsweise eine Induktionsspule, ist in zweckmäßiger Weise in den Kartenkörper integriert oder auf diesem angeordnet, wobei die Verbindungsstellen zu den Anschlußstellen freiliegen. Beispielsweise können im Fall einer in den Kartenkörper integrierten Kupferdrahtspule Verbindungsstellen beim Fräsen der Kavität für den Modul mit freigelegt werden. Bei einer derartigen Anordnung ist es möglich, die Verklebung von Modul und Kartenträger gleichzeitig mit der Herstellung der elektrisch leitenden Verbindungen zwischen dem Mittel für die kontaktlose Datenübertragung und den Anschlußstellen des Moduls durchzuführen. Hierfür kann ein Stempel eingesetzt werden, welcher sowohl Druckkräfte als auch Wärmeenergie zum Herstellen der Klebe- und Lötverbindung bereitstellt.

Um das bekannte übliche Hotmelt-Verfahren einsetzen zu können, wird der Klebstoff, wie erläutert, mit leit- und lötfähigen Partikeln in vorbestimmten Kontaktabschnitten versehen. Die Herstellung der mechanischen Klebeverbindung erfolgt dann in an sich bekannter Weise, wobei die elektrische Verbindung der Kontakte durch gezieltes Einbringen von Wärme mindestens in die Bereiche der Kontaktabschnitte realisiert wird.

Fügeverfahrensseitig wird für die Herstellung einer Chipkarte auf einen den Modul aufnehmenden Stempel zurückgegriffen, mit dessen Hilfe sowohl das Einsetzen des Moduls in die Kartenausnehmung als auch das Ausbilden der elektrischen und mechanischen Verbindung erfolgt. Der Stempel ist mindestens in einem Bereich in dem durch Schmelzklebung oder Lötung Kontakte auszubilden sind beheizbar, so daß lokal sowohl auf das Modul mit dem Halbleiterchip und/oder auf ein Fügehilfsmittel Wärmeenergie aufgebracht werden kann. Die jeweilige Wärmeenergie bzw. Wärmemenge kann lokal unterschiedlich sein, so daß auf unterschiedliche Eigenschaften des Fügehilfsmittels, das eine elektrische und/oder mechanische Verbindung sicherstellt, reagiert werden kann.

Gemäß einem hier ergänzenden Grundgedanken kann durch eine Bewegung des Stempels und/oder von im Stempel befindlichen einzelnen oder gemeinsam bewegten Elementen eine definierte auch unterschiedliche Druckkraft auf das Modul bzw. Modulabschnitte zum Erhalt eine optimalen Fügeverbindung ausgeübt werden.

Bei dem skizzierten Fügeverfahren kann also mittels eines einzigen Vorganges das Aufnehmen und Einsetzen des Moduls im Kartenkörper unter Erhalt der gewünschten Fügeverbindung durchgeführt werden, wobei das Temperatur-Druck-Zeitregime innerhalb des Verfahrens variier- und anpaßbar ist. Ergänzend besteht die Möglichkeit, durch Prüfung der insbesondere der elektrischen Kontaktqualität während des Fügevorganges einzelne Verfahrensparameter, beispielsweise die Temperatur oder örtlich aufzubringende Druckkräfte zu steuern, so daß geringere Übergangswiderstände gewährleistet sind und sich eine hohe Kontaktsicherheit auch bei üblichen Umgebungsbedingungen, denen die Karte ausgesetzt ist, ergibt.

Gemäß der Erfindung wird der Modul, welcher vom Stempel aufgenommen ist im Stempel vorgeheizt und es erfolgt ein Einsetzen des vorgeheizten Moduls in die Kartenausnehmung mit dann vorgesehener weiterer lokaler Erwärmung insbesondere an den Stellen, die zur Ausbildung der Kontaktbereiche d.h. zur elektrischen Fügeverbindung vorgesehen sind.

Das Fügewerkzeug zur Herstellung einer Chipkarte umfassend einen Modul mit Halbleiterchip sowie einen Kartenkörper mit Ausnehmung zur Aufnahme des Moduls mittels Heißkleber und/oder Lötverbindung, besteht aus einem Stempel zur temporären Aufnahme des Moduls und zum Einsetzen desselben in die Kartenkörperausnehmung.

Der Stempel ist mit Mitteln versehen, die ein partielles oder ganzflächiges Beheizen ermöglichen, wobei sowohl auf ein verwendetes Fügehilfsmittel als auch auf den Modul ganz gezielt Wärmeenergie, auch mit örtlich unterschiedlicher Verteilung aufbringbar ist. Hierfür weist erfindungsgemäß der Stempel wärmeleitende Abschnitte auf, die der Übertragung von Wärme ausgehend von einer Wärmequelle zu einer Wärmesenke dienen. Als Wärmesenke wirken die entsprechenden Oberflächenbereiche des Moduls und/oder des Fügehilfsmittels, wobei nicht mit den wärmenleitenden Abschnitten des Stempels in Kontakt stehende Oberflächenbereiche sich auf einem anderem, geringeren Temperaturniveau befinden.

Der Stempel kann aus einer Sandwichstruktur von wärmeleitenden und thermisch isolierenden Abschnitten bestehen, wobei die Sandwichstruktur der jeweiligen Kontaktlage auf dem Modul bzw. der Kartenträgerausnehmung angepaßt ist.

Dadurch, daß wärmeleitende Abschnitte im Stempel beweglich angeordnet sind, kann ein gesteuertes Aufbringen von Wärmeenergie erfolgen, in dem die Zeit des in Kontaktbringens des jeweiligen beweglichen Abschnittes mit dem Oberflächenabschnitt des Moduls gesteuert wird oder indem von vornherein bestimmte beweglich angeordnete Elemente, die Stößel darstellen können, in eine solche Position verbracht sind, daß eine Wärmeübertragung durch Leitung hin zum jeweiligen Oberflächenabschnitt ausgeschlossen ist. Derart ausgebildete Stempel stellen ein Universalwerkzeug dar, das an jeweilige Konfigurationen einzusetzender Module anpaßbar ist.

Gemäß einer vorrichtungsseitigen Ausführungsform der Erfindung können die beweglichen Abschnitte des Stempels, aber auch der Stempel in seiner Gesamtheit mit einer Vorrichtung zur Ausübung einer Druckkraft auf Modul, Fügehilfsmittel und Kartenträger zusammenwirken, so daß gezielt nicht nur Wärmeenergie sondern auch Druckkräfte zum Herstellen der Fügeverbindung erzeugt werden können.

Das Fügewerkzeug zur Herstellung der Chipkarte in Form eines Stempels besitzt Ausnehmungen zur Aufnahme einer Wärmequelle. Diese, vorzugsweise im Inneren des Stempels angeordnete Wärmequelle kann beispielsweise eine Laser-Diode oder eine IR-Diode sein. Mittels der vorgenannten Dioden kann direkt Wärmeenergie auf Abschnitte des Moduls bzw. im Falle von vorhandenen Ausnehmungen im Modul unmittelbar auf das Fügehilfsmittel aufgebracht werden. Das Zwischenschalten von wärmeleitenden Bereichen zur Übertragung der mit den Wärmequellen erzeugten Energie ist im vorstehenden Falle nicht notwendig.

Als Wärmequelle kann jedoch auch eine Widerstandsheizung eingesetzt werden, die entweder nahe der Oberflächen des Stempels, d.h. hin zur jeweiligen gegenüberliegenden Fläche des Moduls angeordnet ist oder die über einen thermisch leitfähigen Abschnitt mit der Oberfläche in Verbindung steht. Letztendlich kann mittels eines Lichtleiters, der in einer Ausnehmung des Stempels fixiert ist, eine Verbindung zu einer externen Wärmequelle, d.h. einer Quelle, die außerhalb des Stempels befindlich ist, hergestellt werden.

In einer weiteren Ausführungsform ist das Fügewerkzeug so ausgebildet, daß der Stempel oder Teile des Stempels mit einer Ultraschall- und/oder Hochfrequenzquelle in Verbindung stehen, so daß ein induktives Erwärmen bei gegebenenfalls gleichzeitiger Einwirkung von Ultraschallenergie zum Erhalt optimaler Kontakte möglich wird.

Vorzugsweise bestehen die wärmeleitenden Abschnitte oder die Teile des Stempels, die mit der vorerwähnten Hochfrequenzquelle in Verbindung stehen aus dem elektrisch leitfähigen Material, insbesondere Metall.

Alles in allem gelingt es mit der Erfindung, ein Verfahren zur Herstellung einer elektrischen und mechanischen Verbindung eines in einer Ausnehmung eines Kartenkörpers einer Chipkarte eingesetzen Moduls anzugeben, wobei einerseits auf bekannte Heiß- oder Schmelzkleber zurückgegriffen werden kann und andererseits sowohl qualitativ hochwertige elektrische Kontakte bzw. elektrische Verbindungen realisiert werden können und die geforderte mechanische Festigkeit des Moduls im Kartenträger gegeben ist, ohne daß im laufenden Betrieb nachteilige Scher- oder sonstige Kräfte auf die Kontaktbereiche einwirken.

Das erfindungsgemäße Verfahren ist insbesondere für kontaktlose Chipkarten oder auch Kombikarten geeignet, bei welchen sowohl mechanisch kontaktierbare Kontaktflächen als auch induktive Komponenten vorhanden sind. Durch die Verwendung der erfindungsgemäß modifizierten Heiß- oder Schmelzkleberfolien können die Kosten bei der Kartenherstellung gesenkt werden, da es nicht notwendig ist, auf kostenintensive anisotrop leitende Klebstoffe zurückzugreifen, die im übrigen zum Verkleben der Module mit dem Kartenkörper nur sehr bedingt geeignet sind.

Durch das nur partielle elektrische Verbinden an den jeweiligen elektrischen Kontaktierungsstellen verbleibt genügend Fläche zur Ausführung der stoffschlüssigen Klebeverbindung, um das Modul sicher im Kartenkörper zu befestigen.

Die Erfindung soll nachstehend anhand von Ausführungsbeispielen unter Zuhilfenahme von Figuren näher erläutert werden.

Hierbei zeigen:
- Fig. 1: einen Schnitt durch einen Hotmelt-Klebstoffilm;
- Fig. 2: eine Draufsicht auf einen präparierten Hotmelt-Film;
- Fig. 3: einen Schnitt durch einen Hotmelt-Film mit im Innern befindlichen leitfähigen Partikeln;
- Fig. 4: eine prinzipielle Schnittdarstellung der Einbauposition des Moduls in der Ausnehmung eines Kartenträgers unter Verwendung des Verbindungsmittels gemäß Ausführungsbeispiel;
- Fig. 5: schematisch einen Querschnitt durch eine Chipkarte im Bereich einer elektrisch leitenden Verbindungsstelle zwischen einer Anschlußstelle und einem Mittel zur kontaktlosen Datenübertragung;
- Fig. 6: eine schematische Skizze zur Erläuterung des Verfahrens, nämlich am Beispiel der Herstellung der elektrisch leitenden Verbindung, die in Fig. 5 dargestellt ist;
- Fig. 7a: eine perspektivische Ansicht des Fügewerkzeuges und
- Fig. 7b: einen Schnitt längs der Linie A-A des Fügewerkzeuges gemäß Fig. 7a.

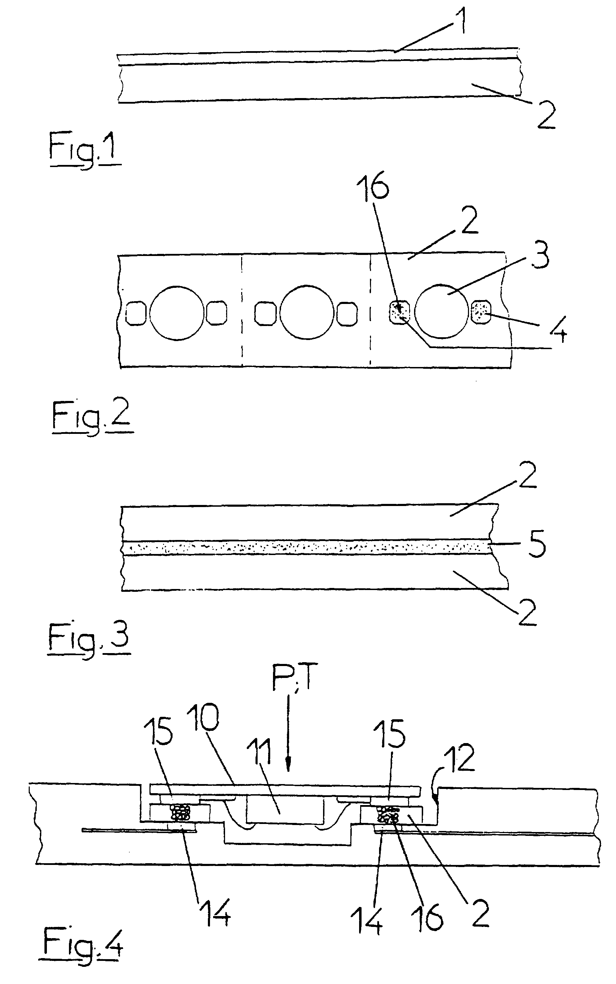

Der in Fig. 1 gezeigte Schnitt durch einen Hotmelt-Film weist eine Trägerfolie 1 auf, die mit einem Heiß- oder Schmelzkleber 2 beschichtet ist. Die Schichtdicke liegt im Bereich zwischen 20 und 80 *µ*m, wobei je nach Kartenmaterial wie ABS, PVC, PC oder PET verschiedene Kleber zum Einsatz kommen.

Der in Fig. 2 gezeigte präparierte Heiß- oder Schmelzkleber weist Lochungen 3 für die Aufnahme des Chips sowie jeweils seitlich angeordnete Abschnitte 4 auf, die aus einer leitfähigen Schicht oder aus leitfähigen Partikeln 16 bestehen bzw. diese enthalten.

Diese Abschnitte 4 können beispielsweise Lochungen oder Ausnehmungen sein, die mit Lötpaste verfüllt wurden. Wie anhand der Fig. 2 erkennbar, ist der auf einer Trägerfolie 1 befindliche Heiß- oder Schmelzkleber 2 konfektioniert. Auf diesen blisterartigen Folienstreifen kann das mit einem Chip 11 versehene Modul 10 (Fig. 4) befestigt werden, um dann in einem nächsten Arbeitsgang das derart mit Trägerfolie 1 und Heiß- oder Schmelzkleber 2 versehene Modul 10 hin zur Ausnehmung 12 eines Kartenkörpers 13 zu positionieren (Fig. 4).

Bei einem weiteren Ausführungsbeispiel wurden Lötkugeln mit einem Durchmesser von 25 *µ* m auf die Heiß- oder Schmelzkleberschicht selektiv aufgebracht, so daß in einem nachfolgenden Druck-Temperatur-Prozeß sowohl eine Lötverbindung zwischen den sich gegenüberliegenden Kontaktflächen unter Rückgriff auf die Lötkugel als auch die Klebeverbindung zwischen Modul und Kartenkörper realisiert werden kann.

Bei dem in der Fig. 3 gezeigten Heiß- oder Schmelzkleber 2 weist dieser eine im Innern befindliche Schicht 5 aus leitfähigen Partikeln auf. In dem Falle, wenn die Konfiguration nach Fig. 3 verwendet wird, sind erhaben ausgebildete Kontaktflächen am Modul bzw. am Kartenkörper in der Lage, beim Druck-Temperatur-Behandlungsschritt den in den halbflüssigen Zustand übergehenden Heiß- oder Schmelzkleber zu verdrängen, um so in Wirkverbindung mit den leitfähigen Partikeln der inneren Schicht zu treten, wodurch sich die gewünschte Kontaktierung ausbildet.

Mit Hilfe der Fig. 4, die eine prinzipielle Schnittdarstellung durch einen Kartenkörper 13 zeigt, welcher eine Ausnehmung 12 aufweist, soll nun das Verfahren zur Verbindungsherstellung erläutert werden.

Der mit der präparierten Heiß- oder Schmelzkleberschicht 2 versehene Modul 10, welcher einen Chip 11 umfaßt, wird z. B. mittels eines geeigneten Werkzeuges in die Ausnehmung 12 positioniert.

Kontaktflächen 14, die mit einer Induktionsspule zur kontaktlosen Datenübermittlung in Verbindung stehen, befinden sich auf der inneren Oberflächenseite der Ausnehmung 12. Durch Ausübung einer Druckkraft in Pfeilrichtung sowie durch Temperatureinwirkung erwärmt sich der Heiß- oder Schmelzkleber in der Schicht 2. Gleichzeitig stellen die leitfähigen Partikel 16, die sich in den Abschnitten 4 bzw. in der Schicht 5 befinden, eine elektrische Verbindung zwischen den Kontaktflächen 14 und den gegenüberliegenden Kontaktflächen 15 des Moduls her. Mit dem Erkalten und Aushärten des Klebers ergibt sich sowohl eine sichere mechanische Verbindung des Moduls 10 in der Ausnehmung 12 des Kartenkörpers 13 als auch eine entsprechende elektrische Verbindung zwischen den Kontaktflächen 14 und 15. In dem Falle, wenn beispielsweise Lötpaste in Ausnehmungen oder Lochungen des Heiß- oder Schmelzklebers 1 eingebracht wird, dient diese zur Realisierung der elektrischen Verbindung zwischen den sich gegenüberliegenden Kontaktflächen 14 und 15.

In einem weiteren Ausführungsbeispiel kann bei Verwendung einer Lötkugel im Kleberfilm während oder nach des Druck-Temperatur-Einwirkschrittes zusätzlich lokal Wärme im Bereich der Kontaktflächen 14 und/oder 15 zur Einwirkung gebracht werden, so daß der gewünschte Lötprozeß vollzogen wird.

Aus den voranstehend geschilderten Ausführungsbeispielen wird deutlich, daß die leitfähigen Partikel oder die leitfähige Schicht sowohl im Innern der Heißklebefolie befindlich sein kann, als auch oberflächenseitig aufbringbar ist. Ein Fixieren einer oberflächenseitig aufgebrachten Schicht oder von oberflächenseitig angeordneten Partikeln kann durch kurzzeitige Wärmebehandlung erfolgen, wodurch die entsprechenden Partikel am Kleber anhaften. Für die Wärmebehandlung kann beispielsweise auf eine beheizte Walze, die über die Folie geführt wird, zurückgegriffen werden, wobei die Walze auch gleichzeitig zum Auftragen der leitfähigen Partikel nutzbar ist.

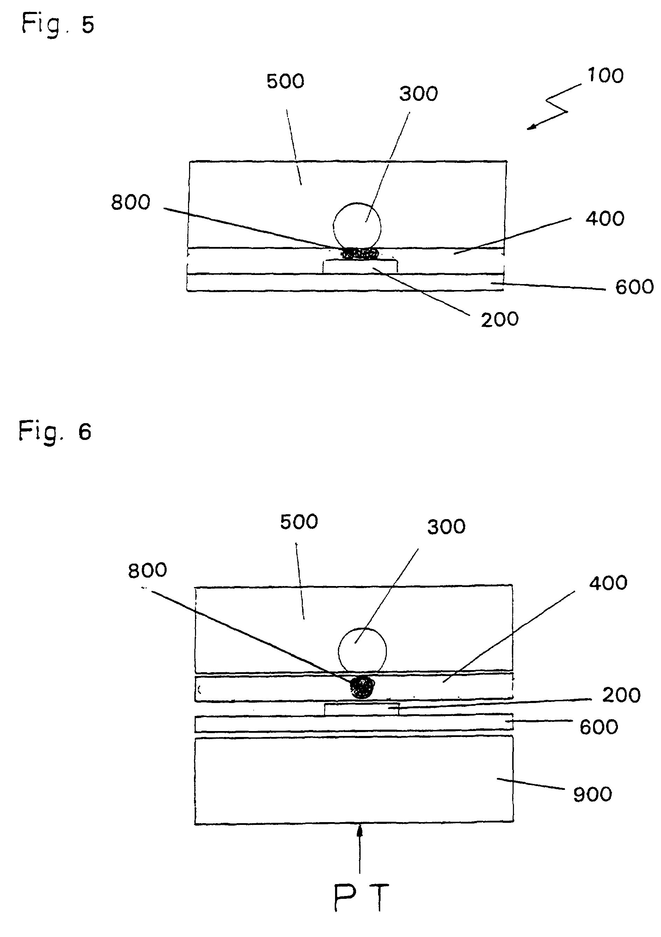

Fig. 5 zeigt einen Querschnitt durch eine Chipkarte 100 im Bereich einer elektrisch leitenden Verbindungsstelle zwischen einer Anschlußstelle 200 und einem Mittel 300 zur kontaktlosen Datenübertragung, hier einer Indukionsspule. Die Induktionsspule 300 ist in den Kartenkörper 500, der üblicherweise aus Kunststoff, z.B. Polycarbonat, besteht, integriert. Im Bereich der Verbindungsstelle ist ein Abschnitt der Spule, beispielsweise durch Fräsen der Kartenkörperoberfläche, freigelegt. Die eine der beiden in Fig. 5 gezeigten Anschlußstellen 200 der Karte zur Spule 300 ist als Metallstreifen auf dem Träger 600 des Moduls, z.B. einer Kunststoffolie, ausgebildet und befindet sich außerhalb des Bereichs des Trägers, in dem der Halbleiterchip angeordnet ist. Die elektrisch leitende Verbindung wird zwischen Anschlußstelle 200 und Induktionsspule 300 mittels Löten in der Kleberschicht 400 selektiv eingebrachter Lötkugeln 800 hergestellt. Im gezeigten Fall wird der Klebstoff im Bereich der gesamten Oberfläche des Moduls aufgetragen, wobei zwischen Induktionsspule 300 und Anschlußstelle 200 die selektiv im Klebstoff befindlichen leit- und lötfähigen Partikel zum Liegen kommen.

Wie erwähnt, wird als bevorzugter Klebstoff ein Heiß- oder Schmelzklebstoff verwendet. Bei Verwendung derartiger Klebstoffe kann die Verbindung vom Modul mit Kunststoffträger 600 und Anschlußstelle 200 zu dem Kartenkörper 500 bei gleichzeitiger Herstellung der Lötverbindung mittels Lötkugeln 800 zwischen Anschlußstelle 200 und Induktionsspule 300 unter Verwendung des weitverbreiteten Hotmelt-Verfahrens erfolgen, wofür ein universeller Heiz- und Druckstempel 900 einsetzbar ist.

Dies ist schematisch in Fig. 6 verdeutlicht, wo ein Querschnitt durch die Chipkarte gemäß Fig. 5 vor Verbindung von Modul und Kartenkörper 500 gezeigt ist.

Der im Bereich der Kavität für den Modul mit Klebstoff beschichtete Kartenkörper 500 mit integrierter Induktionsspule 300 wird in passender Lage auf den Modul mit Träger 600 und Anschlußstelle 200 aufgesetzt. Nun wird mit Hilfe des Heiz- und Druckstempels 900 Druck und Wärme zugeführt. Dadurch erweicht die Klebeschicht 400, und Modul und Kartenkörper 500 werden so weit zusammengedrückt, bis Spule 300, elektrisch leitende Partikel 800 und Anschlußstelle 200 sich berühren und so eine Lötverbindung zustandekommt. Gleichzeitig entsteht eine Klebeverbindung zwischen Oberfläche der Kartenkörperkavität und dem Modul. Anschließend läßt man den Klebstoff durch Erkalten aushärten.

Auf die beschriebene Weise können die Verklebung von Modul und Kartenkörper und die Herstellung elektrisch leitender Verbindungen zum kontaktlosen Datenübertragungssystem in einem Schritt unter Verwendung bekannter Verfahren erfolgen.

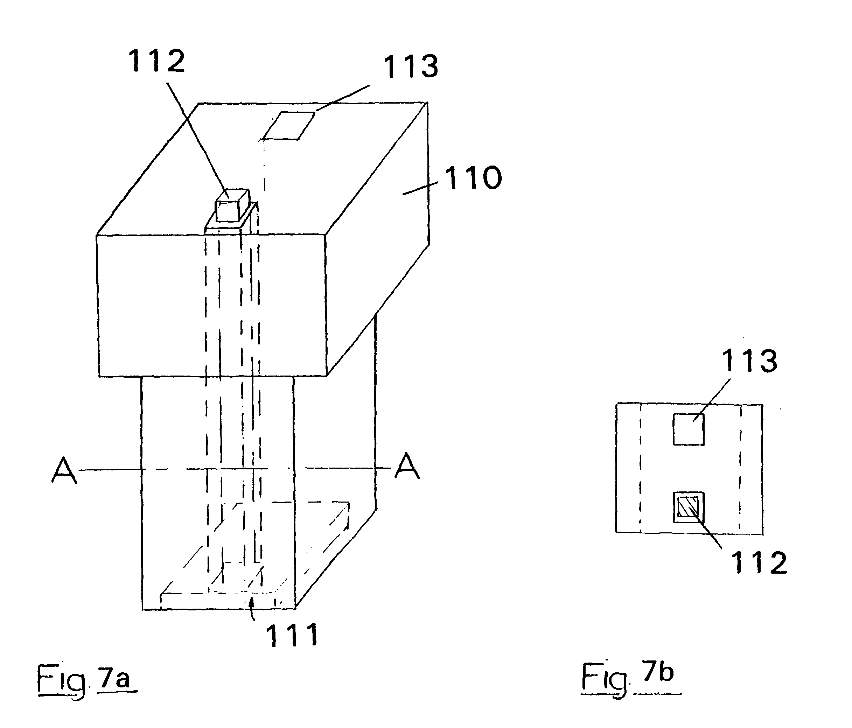

Das Fügewerkzeug gemäß Figur 7a zur Herstellung einer Chipkarte, die aus einem Modul mit einem Halbleiterchip sowie einem Kartenkörper mit Ausnehmung zur Aufnahme des Moduls besteht, wobei der Modul mittels Heißkleben und/oder Lötverbindung im Kartenkörper fixiert ist, umfaßt einen Stempel 110. Dieser Stempel 110 weist in einem unterem Bereich eine Ausnehmung 111 auf, in die der Modul (nicht gezeigt) eingesetzt werden kann.

Beim gezeigten Ausführungsbeispiel gemäß Figur 7a ist ein sich durch die Längsachse des Stempels 110 erstreckender wärmeleitender Abschnitt in Form eines Stößels 112 angeordnet. Das untere Ende des Stößels 112 steht mit einem entsprechenden Abschnitt des an der Ausnehmung 111 befindilchen Moduls in Verbindung, so daß gezielt Wärmeenergie vom oder über den Stößel 112 hin zur Oberfläche des Moduls übertragen werden kann. Zur lokalen Begrenzung der Wärmeübertragung sowie zur Reduzierung der insgesamt notwendigen Wärmemenge ist der Stößel 112 innerhalb einer Längsbohrung 113, die durch den Stempel 110 verläuft, isoliert gelagert.

Alternativ kann in der Längsbohrung 113 eine Wärmequelle, zum Beispiel eine Laser- oder IR-Diode angeordnet sein, deren Strahlrichtung zur Oberfläche des in der Ausnehmung 111 befindlichen Modules zeigt.

Anstelle der Ausbildung einer Längsbohrung 113 mit gegebenenfalls beweglichen wärmeleitenden Stößel 112 kann der Stempel eine Sandwichstruktur aus wärmeleitfähigen und nichtwärmeleitfähigen Abschnitten umfassen, wobei die Sandwichstruktur der Lage der Kontakte auf dem Modul bzw. den Orten einzubringender Wärmeenergie angepaßt ist.

Gemäß einem weiterem Ausführungsbeispiel sind mehrere Längsbohrungen 113 und Stößel 112 vorgesehen, wobei die Stößel 112 je nach aufgenommenen Modul mit entsprechenden Oberflächen des Moduls in Kontakt bringbar sind, wodurch eine universelle Verwendbarkeit des Stempels 110 gewährleistet ist.

Wenn im Falle von Multilayerstrukturen ein gezieltes Aufbringen von Wärmeenergie lokal unterhalb des Moduls hin zum Kartenträger notwendig wird, dann kann im Modul eine Ausnehmung oder Durchgangsbohrung vorhanden sein und es besteht in diesem Falle die Möglichkeit den Stößel durch diese Bohrung hindurch direkt mit dem darunter befindlichen Multilayer bzw. Kartenkörper in Verbindung zu bringen und Wärmeenergie einwirken zu lassen, so daß erforderliche Kontaktverbindungen ausbildbar sind.

Selbstverständlich können gemäß einer nicht gezeigten Ausführungsform im unteren Bereich des Stempels 110 eine Vielzahl von Wärmequellen zum Beispiel in Form von Widerstandsheizungen integriert sein, die ebenfalls einzeln oder in Gruppen ansteuerbar sind, um eine gewünschte Temperaturverteilung entsprechend dem jeweiligen Modul oder der gewünschten Kontaktlage einzustellen.

Die in der Längsbohrung 113 befindlichen Stößel 112 dienen bei einem weiterem Ausführungsbeispiel nicht nur dem definierten Aufbringen von Wärmeenergie bezogen auf Obeflächenabschnitte des Moduls, sondern können auch zum Einbringen bzw. Aufbringen von Druckkräften Verwendung finden.

Der mit dem Modul versehende Stempel wird zur Durchführung des Fügeverfahrens analog einer Chip-Bond-Station hin zur Ausnehmung des Kartenkörpers verbracht und dort positioniert. Unter Rückgriff auf die in dem vorstehenden Ausführungsbeispiel beschriebenen Ausgestaltungen des Stempels erfolgt nun das lokale Aufbringen von Wärme und/oder Druck, so daß das Modul mit darauf befindlichen Halbleiterchip mechanisch und elektrisch mit dem Kartenkörper verbunden werden kann.

Die Parameter zur Steuerung der Fügeverbindung können in Abhängigkeit, zum Beispiel vom ermittelten elektrischen Kontaktwiderstand während des Fügens vorgegeben werden. Durch diese Maßnahme wird sichergestellt, daß das Aufbringen von zu großer Wärme- und/oder Druckenergie mit Sicherheit ausgeschlossen wird, so daß sich die Qualität der Fügeverbindung insgesamt erhöht. Insbesondere werden durch eine derartige Parametervorgabe thermische Zersetzungsprozesse eines verwendeten Heiß- bzw. Schmelzklebers verhindert oder Beschädigungen des Kartenträgers bzw. der im Innern des Trägers befindlichen Elemente ausgeschlossen.

Bei der Schnittdarstellung gemäß Figur 7b wird deutlich, daß sich durch Anordnung der Stößel 112 in der bzw. den Längsbohrungen 113 Bereiche ergeben, die jeweils bezogen auf die Umgebung zur unterschiedlichen Druck und/oder Temperatureinwirkung auf das Modul bzw. entsprechende Oberflächenabschnitte des Moduls geeignet sind.

In einem weiteren Ausführungsbeispiel befinden sich innerhalb der Längsbohrungen 113 Lichtleiter, die mit einer externen, außerhalb des Stempels 110 angeordneten Wärmequelle zusammenwirken. In diesem Falle kann auf eine Isolierung innerhalb der Längsbohrungen 113 bzw. zur Stempelumgebung hin verzichtet werden.

Mit einem vorgesehenen Raster von Längsbohrungen an potentiellen Kontaktstellen außenumfangsseitig des Stempels kann entsprechend der jeweiligen Konfiguration aus Modul und Kartenkörper ein selektives Einführen von Lichtleitern je nach Anwendung erfolgen, wodurch sich wiederum die Universalität des Fügewerkzeuges erhöht.

Letztendlich kann, wie erläutert, der Stempel oder Teile hiervon mit einem Ultraschallgenerator in Verbindung stehen, so daß insbesondere während des Fügeprozesses durch Aufbringen von Ultraschallenergie sich die insgesamt zur Fügeverbindung erforderliche Wärmeenergie reduzieren läßt und eine weitere Verbesserung der Erhöhung der Kontaktqualität und Kontaktzuverlässigkeit die Folge ist.

Alternativ zur Anordnung von diskreten Wärmequellen bzw. Wärmeleitern besteht die Möglichkeit, daß der Stempel oder Teile des Stempels mit einer Hochfrequenz-Quelle in Verbindung stehen, so daß eine induktive Erwärmung möglich wird.

Alles in allem gelingt es mit dem Fügewerkzeug gemäß den voranstehenden Ausführungsbeispielen bzw. einem entsprechenden Fügeverfahren Chipkarten herzustellen, die ausgezeichnete, langzeitstabile elektrische und mechanische Verbindungen zwischen einem Modul mit Halbleiterchip und Kartenkörper aufweisen. Durch das spezielle Fügewerkzeug ist eine universelle Verwend- und Einsetzbarkeit gegeben, so daß sich die Kosten bei der Fertigung entsprechender Chipkarten reduzieren und sich die Effizienz des Fügeverfahrens erhöht.

### Bezugszeichenliste

- 1: Trägerfolie
- 2: Heiß- oder Schmelzkleber
- 3: Lochung für Chip
- 4: Abschnitte
- 5: innere Schicht
- 10: Modul
- 11: Chip
- 12: Ausnehmung
- 13: Kartenträger
- 14: Kontaktflächen Kartenträger
- 15: Kontaktflächen Modul
- 16: leitfähige Partikel
- 100: Chipkarte
- 200: Anschlußstelle
- 300: Induktionsspule
- 400: Kleberschicht
- 500: Kartenträger
- 600: Träger
- 800: Lötkugeln
- 110: Stempel
- 111: Ausnehmung
- 112: Stößel
- 113: Längsbohrung

## Patentansprüche

1. Verfahren zur Herstellung einer elektrischen und mechanischen Verbindung eines in einer Ausnehmung eines Kartenkörpers einer Chipkarte eingesetzten Moduls unter Verwendung eines Heiß- oder Schmelzklebers,
**dadurch gekennzeichnet, daß**
- in die auf einem folienartigen Träger befindliche, nicht leitende Heiß- oder Schmelzkleberschicht im Bereich auszubildender elektrischer Kontakte zwischen Modul und Kartenkörper Ausnehmungen oder Lochungen eingebracht werden, welche mit leitfähigen Lot-Partikeln verfüllt werden,
- anschließend die so vorbereitete Heiß- oder Schmelzkleberschicht am Modul oder in der Ausnehmung des Kartenkörpers fixiert wird, wobei die mit den leitfähigen Lot-Partikeln versehenen Abschnitte sich zwischen den Kontaktflächen des Moduls und der Ausnehmung des Kartenkörpers befinden und
- weiterhin in einem Druck-Temperatur-Einwirkungsschritt sowohl die mechanische Verbindung zwischen Modul und Kartenkörper als auch die elektrische Kontaktierung, letztere durch Lötung realisiert wird.

2. Verfahren nach Anspruch 1,
**dadurch gekennzeichnet, daß**
je nach gegebenem Material des Kartenkörpers und des Moduls geeignete Heiß- oder Schmelzkleber ausgewählt und diese hinsichtlich ihrer Schichtdicke und Auswahl der leitfähigen Lot-Partikel für den jeweiligen Einsatzfall individuell präpariert werden.

3. Verfahren nach Anspruch 1 oder 2,
**dadurch gekennzeichnet, daß**
die leitfähigen Lot-Partikel mittels Dispenser, Walze oder Stempel lokal, gegebenenfalls mittels einer Maske aufgebracht werden, wobei durch gleichzeitige oder anschließende kurzzeitige Wärmebehandlung die Lot-Partikel oder die Schichtbestandteile mit der Kleberschicht haftend verbunden werden.

4. Verfahren zum Herstellen einer Chipkarte, wobei ein auf einem Modul befindlicher Halbleiterchip in eine Ausnehmung eines Kartenkörpers unter Erhalt einer Verbindung eingesetzt wird, wobei das Einsetzen des Moduls in die Kartenausnehmung mittels eines das Modul aufnehmenden Stempels (10) erfolgt, wobei der Stempel mindestens in einem Bereich beheizbar ist, so daß lokal auf das Modul und ein Fügehilfsmittel Wärmeenergie aufgebracht werden kann und zusätzlich Druckkraft zum Erhalt der Fügeverbindung ausübbar ist,
**dadurch gekennzeichnet, daß**
die Wärmeenergie für durch Schmelzklebung oder Lötung auszubildende elektrische Kontakte zugeführt wird, wobei der Stempel vorgeheizt ist und an Kontaktstellen eine weitere, lokale Erwärmung erfolgt und von im Stempel befindlichen einzeln oder gemeinsam beweglichen Elementen zeitweise zusätzliche Druckkräfte auf Modul, Fügehilfsmittel und Kartenkörper ausgeübt werden.

5. Fügewerkzeug zur Herstellung einer Chipkarte gemäß einem Verfahren nach Patentanspruch 4, bestehend aus einem Modul mit Halbleiterchip sowie einem Kartenkörper mit Ausnehmung zur Aufnahme des Moduls mittels Heißkleben, Kaltkleben und Lötverbindung mit einem beheizbaren Stempel zur temporären Aufnahme des Moduls und zum Einsetzen in die Kartenkörperausnehmung, so daß sowohl auf ein Fügehilfsmittel als auch auf das Modul Wärmeenergie aufbringbar ist, wobei
der Stempel mindestens einen sich durch die Stempellängsachse erstreckenden Stößel aufweist, der der Übertragung von Wärme von einer Wärmequelle zu einer Wärmesenke dient, wobei die Wärmesenke durch Obenflächenbereiche des Moduls und des Fügehilfsmittels gebildet ist, welche mit dem unteren Ende des Stößels jeweils in Verbindung stehen, und wobei mittels des Stößels eine Druckkraft ausübbar ist,
**dadurch gekennzeichnet, daß**
der Stößel für eine zusätzliche, lokal begrenzte Übertragung von Wärme auf die Oberflächenbereiche ausgebildet ist.

6. Fügewerkzeug nach Anspruch 5,
**dadurch gekennzeichnet, daß**
der Stempel aus einer Sandwichstruktur von wärmeleitenden und thermisch isolierenden Abschnitten besteht.

7. Fügewerkzeug nach Anspruch 5 oder 6,
**dadurch gekennzeichnet, daß**
die im Stempel angeordneten Elemente selektiv mit dem jeweiligen Oberflächenabschnitt des Moduls und/oder des Fügehilfsmittels in Kontakt bringbar sind.

8. Fügewerkzeug nach einem der Ansprüche 5 bis 7,
**dadurch gekennzeichnet, daß** der Stempel Ausnehmungen oder Bohrungen zur Aufnahme einer Wärmequelle aufweist.

9. Fügewerkzeug nach Anspruch 8,
**dadurch gekennzeichnet, daß**
als Wärmequelle eine Laser-Diode, IR-Diode oder dergleichen Quelle eingesetzt ist.

10. Fügewerkzeug nach Anspruch 8,
**dadurch gekennzeichnet, daß**
als Verbindung zu einer extern angeordneten Wärmequelle ein Lichtleiter eingesetzt ist.

11. Fügewerkzeug nach einem der Ansprüche 5 bis 10,
**dadurch gekennzeichnet, daß**
der Stempel oder Teile hiervon mit einer Ultraschall- und/oder HF-Quelle in Verbindung steht.

12. Fügewerkzeug nach Anspruch 11,
**dadurch gekennzeichnet, daß**
die wärmeleitenden Abschnitte oder die Teile des Stempels, die mit der HF-Quelle in Verbindung stehen, elektrisch leitfähig sind.

13. Fügewerkzeug nach einem der Ansprüche 5 bis 12,
**gekennzeichnet durch**
den Anschluß eines Prüfgerätes zum Feststellen der Qualität ausgebildeter elektrischer Kontakte während des Fügens sowie zur Steuerung und Vorgabe von Fügeparametern.

## Claims

1. A method for producing an electrical and mechanical connection of a module inserted in a recess of a card body of a chip card using a hot-setting or hot-melt adhesive,
**characterised in that**
- recesses or perforations are made in the non-conductive hot-setting or hot-melt adhesive layer, located on a film-like substrate, in the region of electrical contacts to be formed between the module and the card body, which recesses or perforations are filled with conductive solder particles,
- the hot-setting or hot-melt adhesive layer prepared in this way is then fixed on the module or in the recess of the card body, wherein the portions provided with the conductive solder particles are located between the contact surfaces of the module and the recess of the card body, and
- further, in a pressure-temperature-effect step, both the mechanical connection between the module and the card body and the electrical contacting are implemented, the latter by means of soldering.

2. A method according to claim 1,
**characterised in that**
suitable hot-setting or hot-melt adhesives are selected, depending on the given material of the card body and of the module, and these are prepared individually with respect to their layer thickness and the choice of conductive solder particles for the particular application.

3. A method according to claim 1 or 2,
**characterised in that**
the conductive solder particles are applied by means of a dispenser, roller or stamp locally, optionally by means of a mask, wherein the solder particles or the layer constituents are joined so as to be bonded to the adhesive layer by means of a simultaneous or subsequent short-duration heat teatment,

4. A method for producing a chip card, wherein a semiconductor chip located on a module is inserted in a recess of a card body, thereby obtaining a connection. wherein the insertion of the module in the card recess is effected by means of a stamp (10) which holds the module, wherein the stamp is heatable at least in one region, so that heat energy may be applied locally to the module and to a joining aid and in addition a pressing force may be exerted to obtain the joining connection,
**characterised in that**
the heat energy is supplied for electrical contacts which are to be formed by means of hot-melt adhesion or soldering, wherein the stamp is preheated and further, local heating is effected at contact points and additional pressing forces are exerted on the module, the joining aid and the card body for a time by elements located in the stamp which are movable singly or together.

5. A joining tool for producing a chip card in accordance with a method according to claim 4, consisting of a module with a semiconductor chip and also a card body with a recess for holding the module by means of hot-setting adhesion, cold-setting adhesion and joining by soldering, with a heatable stamp for temporarily holding the module and for inserting it in the card body recess, so that heat energy may be applied both to a joining aid and also to the module, wherein
the stamp has at least one ram extending through the longitudinal axis of the stamp which serves to transfer heat from a heat source to a heat sink, wherein the heat sink is formed by surface regions of the module and of the joining aid which are respectively in contact with the lower end of the ram, and wherein a pressing force may be exerted by means of the ram,
**characterised in that**
the ram is designed for an additional, locally limited transfer of heat to the surface regions.

6. A joining tool according to claim 5,
**characterised in that**
the stamp consists of a sandwich structure of heat-conducting and thermally insulating portions.

7. A joining tool according to claim 5 or 6,
**characterised in that**
the elements arranged in the stamp may be selectively brought into contact with the respective surface portion of the module and/or of the joining aid.

8. A joining tool according to one of claims 5 to 7,
**characterised in that**
the stamp has recesses or bores to accommodate a heat source.

9. A joining tool according to claim 8,
**characterised in that**
a laser diode, infrared diode or a source of that kind is used as heat source.

10. A joining tool according to claim 8,
**characterised in that**
a light guide is used as connection to an externally disposed heat source.

11. A joining tool according to one of claims 5 to 10,
**characterised in that**
the stamp or parts thereof are in contact with an ultrasonic and/or high-frequency source.

12. A joining tool according to claim 11,
**characterised in that**
the heat-conducting portions or the parts of the stamp which are in contact with the high-frequency source are electrically conductive.

13. A joining tool according to one of claims 5 to 12,
**characterised by**
the connection of a testing device to determine the quality of electrical contacts formed during the joining process and to control and preset joining parameters.

## Revendications

1. Procédé de fabrication d'une liaison électrique et mécanique d'un module employé comme corps de carte d'une carte à puce en utilisant un adhésif à chaud ou à fusion, **caractérisé en ce que**
- dans la couche d'adhésif à chaud ou à fusion non conductrice située sur un support de type film, au niveau des contacts électriques à former entre module et corps de carte, sont réalisés des évidements ou des perçages qui sont remplis de particules de brasure conductrices,
- la couche d'adhésif à chaud ou à fusion ainsi préparée est ensuite fixée sur le module ou dans l'évidement du corps de carte, les découpes munies de particules de brasure conductrices se trouvant entre les surfaces de contact du module et l'évidement du corps de carte, et
- ensuite, par une étape d'exposition à la pression et à la température, la liaison mécanique entre module et corps de carte et la mise en contact électrique, cette dernière par brasure, sont réalisées.

2. Procédé selon la revendication 1, **caractérisé en ce que**, selon le matériau donné du corps de carte et du module, des adhésifs à chaud ou à fusion appropriés sont choisis et ceux-ci sont préparés individuellement pour chaque application en termes d'épaisseur de couche et de choix des particules de brasure conductrices.

3. Procédé selon la revendication 1 ou 2, **caractérisé en ce que** les particules de brasure conductrices sont appliquées localement au moyen d'un distributeur, d'un rouleau ou d'un tampon, éventuellement à l'aide d'un masque, un traitement thermique de courte durée, simultané ou ultérieur, faisant adhérer les particules de brasure ou les éléments de la couche à la couche d'adhésif.

4. Procédé de fabrication d'une carte à puce, une puce semi-conductrice située sur un module étant insérée dans un évidement d'un corps de carte avec obtention d'une liaison, l'insertion du module dans l'évidement de la carte s'effectuant au moyen d'un tampon (10) recevant le module, le tampon pouvant être chauffé au moins dans une zone, de sorte que de l'énergie calorifique peut être appliquée localement sur le module et un auxiliaire d'assemblage, et une force de pression peut être appliquée en plus pour obtenir la liaison d'assemblage,
**caractérisé en ce que** l'énergie calorifique est introduite pour des contacts électriques devant être formés par collage sous fusion ou par brasure, le tampon étant préchauffé et, au niveau des zones de contact, un autre chauffage local ayant lieu et des éléments mobiles isolément ou en commun et situés dans le tampon pouvant exercer temporairement une force de pression supplémentaire sur le module, l'auxiliaire d'assemblage et le corps de carte.

5. Outil d'assemblage pour fabriquer une carte à puce selon un procédé selon la revendication 4, composé d'un module avec une puce semi-conductrice et d'un corps de carte avec un évidement pour recevoir le module par collage à chaud, collage à froid et assemblage brasé avec un tampon chauffant afin de loger temporairement le module et de l'insérer dans l'évidement du corps de carte, de sorte que de l'énergie calorifique peut être appliquée à la fois sur un auxiliaire d'assemblage et sur le module, le tampon présentant au moins un poinçon s'étendant sur l'axe longitudinal du tampon, qui sert à transmettre la chaleur d'une source de chaleur à un puits de chaleur, le puits de chaleur étant formé par des zones de surface du module et de l'auxiliaire d'assemblage, lesquels sont en liaison avec l'extrémité inférieure du poinçon, et le poinçon permettant d'appliquer une force de pression,
**caractérisé en ce que** le poinçon est conformé pour une application supplémentaire localement limitée de chaleur sur les zones de surface.

6. Outil d'assemblage selon la revendication 5, **caractérisé en ce que** le tampon se compose d'une structure sandwiche faite de sections conduisant la chaleur et de sections isolantes thermiques.

7. Outil d'assemblage selon la revendication 5 ou 6, **caractérisé en ce que** des éléments placés dans le tampon peuvent être amenés de manière sélective en contact avec la section de surface respective du module et/ou de l'auxiliaire d'assemblage.

8. Outil d'assemblage selon l'une des revendications 5 à 7, **caractérisé en ce que** le tampon présente des évidements ou des perçages pour recevoir une source de chaleur.

9. Outil d'assemblage selon la revendication 8, **caractérisé en ce qu'**on utilise comme source de chaleur une diode laser, une diode à infrarouges ou une source analogue.

10. Outil d'assemblage selon la revendication 8, **caractérisé en ce qu'**on utilise un conducteur optique comme liaison avec une source de chaleur placée à l'extérieur.

11. Outil d'assemblage selon l'une des revendications 5 à 10, **caractérisé en ce que** le tampon ou des parties de lui sont en liaison avec une source d'ultrasons et/ou de hautes fréquences.

12. Outil d'assemblage selon la revendication 11, **caractérisé en ce que** les sections conductrices thermiques ou les parties du tampon qui sont en liaison avec la source de hautes fréquences sont conductrices électriques.

13. Outil d'assemblage selon l'une des revendications 5 à 12, **caractérisé par** le raccordement d'un appareil de mesure afin de vérifier la qualité des contacts électriques formés pendant l'assemblage, ainsi qu'afin de réguler et d'imposer des paramètres d'assemblage.
